(19) Europäisches Patentamt / European Patent Office / Office européen des brevets

(11) **EP 4 478 416 A1**

(12) **DEMANDE DE BREVET EUROPEEN**

(43) Date de publication:
**18.12.2024 Bulletin 2024/51**

(21) Numéro de dépôt: **24181316.1**

(22) Date de dépôt: **11.06.2024**

(51) Classification Internationale des Brevets (IPC):
**H01L 27/146** (2006.01)   **H01L 31/0216** (2014.01)

(52) Classification Coopérative des Brevets (CPC):
**H01L 27/14685; H01L 27/14621**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **13.06.2023 FR 2305964**

(71) Demandeur: **Commissariat à l'Energie Atomique et aux Energies Alternatives**
**75015 Paris (FR)**

(72) Inventeur: **PALANCHOKE, Ujwol**
**38054 GRENOBLE CEDEX 09 (FR)**

(74) Mandataire: **Cabinet Camus Lebkiri**
**25 rue de Maubeuge**
**75009 Paris (FR)**

(54) **PROCÉDÉ DE FABRICATION D'UN FILTRE MULTISPECTRAL POUR UNE RADIATION ÉLECTROMAGNÉTIQUE**

(57) L'invention concerne un procédé (100) de fabrication d'un filtre multispectral pour une radiation électromagnétique comportant au moins deux filtres, chaque filtre comportant une première couche réfléchissante, une deuxième couche réfléchissante, une couche diélectrique de cavité de Fabry-Pérot, le procédé comportant les étapes de :

- Dépôt (101) sur un substrat porteur comportant au moins deux transducteurs photoélectriques, d'une couche de matériau de structuration;

- Structuration (101) en 3D de la couche de matériau de structuration de sorte à obtenir au moins deux motifs de hauteurs différentes, un des motifs présentant une hauteur maximale de référence relativement au substrat porteur ;

- Dépôt conforme (104) d'une première couche réfléchissante ;

- Dépôt (105) d'une couche réalisée dans le matériau diélectrique destiné à former les motifs diélectriques des cavités de Fabry-Pérot ;

- Planarisation (106) par retrait du matériau diélectrique avec arrêt sélectif au sommet du motif de matériau de structuration le plus haut;

- Dépôt (107) d'une couche réalisée dans le même matériau diélectrique de façon à finaliser la formation des cavités de Fabry-Pérot et d'une seconde couche réfléchissante sur les deux cavités de Fabry-Pérot.

[Fig. 1]

**Description**

## DOMAINE TECHNIQUE DE L'INVENTION

Le domaine technique de l'invention est celui du filtrage spectral, notamment pour des applications d'imagerie et la réalisation de filtres colorés pour les capteurs d'images de type CMOS, les dispositifs d'affichage à cristaux liquides ou des diodes électroluminescentes. L'invention peut également être mise en en oeuvre dans des dispositifs d'émission de la lumière.

La présente invention concerne un procédé de fabrication d'un filtre multispectral pour une radiation électromagnétique.

## ARRIERE-PLAN TECHNOLOGIQUE DE L'INVENTION

Un filtre spectral ou encore un filtre de couleur permet de filtrer la lumière par longueur d'onde, de façon à fournir une information sur l'intensité de la lumière dans certaines longueurs d'onde. Plusieurs filtres de couleur peuvent être associés de façon à former, par exemple, des filtres rouge-vert-bleu (RGB dans la terminologie anglaise) qui renseignent sur l'intensité de ces trois couleurs.

On connait notamment des filtres de couleur de type métal/diélectrique réalisés à partir d'une cavité de Fabry-Pérot. Ces filtres comprennent une ou plusieurs cavités diélectriques (ou éventuellement semiconductrices) formées entre deux films minces de métal ayant une fonction de miroir métallique de façon à former une cavité de Fabry-Pérot. Généralement, les empilements métal/diélectrique sont différents suivant la position sur le composant optoélectronique (un capteur d'image par exemple). La transmission du filtre est réglée en ajustant l'épaisseur de la cavité. Ainsi, en fonctionnement, une partie de la lumière incidente correspondant à la longueur d'onde du filtre est transmise à travers celui-ci sous la forme d'un faisceau coloré, tandis que le reste de la lumière incidente est réfléchie. De façon générale, l'épaisseur de la couche diélectrique fixe la longueur d'onde centrale transmise, tandis que l'épaisseur des couches métalliques permet de régler la largeur spectrale de transmission. Par ailleurs, l'utilisation de plusieurs cavités de Fabry-Pérot permet de modifier le profil spectral de la transmission du filtre. Un filtre de ce type est réalisé en utilisant des techniques classiques de fabrication de semi-conducteurs. Ainsi, pour obtenir un filtre rouge-vert-bleu, il convient de former au moins une cavité diélectrique dont l'épaisseur doit présenter trois valeurs différentes. Cela entraîne des contraintes technologiques importantes, notamment au moins une étape de masquage puis de gravure pour chaque cavité diélectrique réalisée.

Il a également été montré que l'on pouvait utiliser un réseau de filtres multispectraux pour l'imagerie directement réalisé sur un réseau de capteurs optiques selon une technique de fabrication compatible CMOS (approche bottom-up selon la terminologie anglaise).

Plus récemment, il a également été décrit dans le document GB2574805 la faisabilité de dispositifs optiquement fonctionnels suite à la création de cavités de Fabry-Pérot au-dessus d'un dispositif capteur d'image CMOS en utilisant une technique de lithographie en niveaux de gris dite Grayscale. Le procédé de fabrication du filtre multispectral de ce document repose sur les étapes suivantes :

- Dépôt d'une première couche métal sur un substrat comportant des transducteurs photoélectriques de type CMOS ;

- Structuration d'une couche de résine par lithographie Grayscale de façon à créer une pluralité de motifs de résine , chaque motif formant une cavité de Fabry-Pérot ;

- Dépôt d'une seconde couche de métal sur les motifs.

Cette dernière solution présente également certains inconvénients. Le premier d'entre eux consiste à réaliser une lithographie Grayscale sur un empilement comportant déjà une couche métallique : un phénomène de réflexion à l'interface métal-résine est alors susceptible d'affecter grandement le contrôle de l'épaisseur de résine durant la lithographie. En outre, la lithographie Grayscale permet d'obtenir des épaisseurs de motifs de résine minimales de 40 ou 50 nm : une telle valeur est suffisante dans le domaine du visible mais il peut être nécessaire d'obtenir des épaisseurs plus faibles pour filtrer des longueurs d'onde inférieures dans d'autres gammes spectrales. De telles épaisseurs inférieures à 40-50 nm sont difficiles à obtenir avec l'utilisation de la lithographie Grayscale telle que décrite dans le document GB2574805.

## RESUME DE L'INVENTION

L'invention offre une solution aux problèmes évoqués précédemment, en proposant un procédé de fabrication d'un filtre multispectral pour une radiation électromagnétique permettant de mieux contrôler les épaisseurs des cavités Fabry-Pérot et d'obtenir des épaisseurs de cavités Fabry-Pérot inférieures à 40 nm.

Pour ce faire, l'invention a pour objet un procédé de fabrication d'un filtre multispectral pour une radiation électromagnétique, ledit filtre comportant au moins deux filtres de couleur, chaque filtre comportant une première couche réfléchissante, une deuxième couche réfléchissante, une couche en matériau diélectrique de cavité de Fabry-Pérot entre la première couche réfléchissante et la deuxième couche réfléchissante, l'épaisseur de la couche diélectrique des deux filtres de couleurs étant différente et chacun des deux filtres étant en regard d'un transducteur photoélectrique, ledit procédé comportant les étapes suivantes :

- Dépôt sur un substrat porteur comportant au moins deux transducteurs photoélectriques, d'une couche de matériau de structuration ;

- Structuration en trois dimensions de la couche de matériau de structuration de sorte à obtenir au moins deux motifs de matériau de structuration de hauteurs différentes, au moins un des motifs présentant une hauteur maximale de référence relativement au substrat porteur, la hauteur étant mesurée perpendiculairement au plan du substrat, chacun des motifs étant en regard d'un transducteur photoélectrique ;

- Dépôt conforme d'une première couche réfléchissante sur les au moins deux motifs de matériau de structuration ;

- Dépôt d'une couche réalisée dans le matériau diélectrique destiné à former les motifs diélectriques des cavités de Fabry-Pérot, ladite couche de matériau diélectrique recouvrant la totalité des motifs en présentant une surface supérieure dont chaque point est situé à une hauteur supérieure à la hauteur maximale de référence ;

- Planarisation par retrait du matériau diélectrique avec arrêt sélectif au sommet du motif de matériau de structuration le plus haut recouvert de la couche réfléchissante ;

- Dépôt d'une couche réalisée dans le même matériau diélectrique de façon à finaliser la formation des cavités de Fabry-Pérot ;

- Dépôt d'une seconde couche réfléchissante sur les au moins deux cavités de Fabry-Pérot.

Grâce à l'invention, les cavités Fabry Pérot sont réalisées avec une étape de structuration, par exemple via une lithographie Grayscale, réalisée avant l'étape de dépôt de la première couche réfléchissante. Cette caractéristique permet d'éviter les inconvénients liées au phénomène de réflexion à l'interface métal-résine. En outre, l'épaisseur de la cavité d'épaisseur la plus faible est directement fixée par l'épaisseur de la couche diélectrique réalisée lors du second dépôt de matériau diélectrique directement sur la première couche réfléchissante. En effet, ce dépôt est précédé d'une étape de planarisation avec arrêt sur le sommet du motif de matériau de structuration recouvert de la couche réfléchissante : ainsi, c'est bien l'épaisseur de la seconde couche de matériau diélectrique qui permet de fixer l'épaisseur de la cavité Fabry-Pérot la plus faible. En procédant de la sorte, le procédé selon l'invention s'affranchit des limites de contrôle d'épaisseur liées à la lithographie Grayscale, et permet, par des techniques de dépôt classique, d'atteindre des épaisseurs beaucoup plus faibles que celles des solutions connues, notamment inférieures à 40 nm. On notera enfin que le procédé selon l'invention s'applique à tout type de substrat, qu'ils s'agissent de substrat intégrant des photodétecteurs CMOS ou de substrat transparent, par exemple en verre, les photodétecteurs étant par exemple disposés sous le substrat. A ce titre, on entend par « substrat porteur » à la fois le substrat et les transducteurs photoélectriques que ces derniers soient intégrés au substrat ou au-dessus ou en dessous dudit substrat.

On entend par « transducteurs photoélectriques » des dispositifs qui peuvent fonctionner soit en tant que collecteur de lumière issue des filtres soit en tant qu'émetteur de lumière vers les filtres. S'il s'agit de collecteurs, les transducteurs peuvent être par exemple des photodiodes de type CMOS. S'il s'agit d'émetteurs, les transducteurs peuvent être par exemple des diodes LED, des diodes de type QLED ou des diodes LASER, les émetteurs présentant dans ce cas un spectre d'émission plus large que celui des cavités de Fabry-Pérot correspondantes.

Outre les caractéristiques qui viennent d'être évoquées dans le paragraphe précédent, le procédé l'invention peut présenter une ou plusieurs caractéristiques complémentaires parmi les suivantes, considérées individuellement ou selon toutes les combinaisons techniquement possibles :

- Selon un premier mode de réalisation, le matériau de structuration est une résine, ladite étape de structuration étant réalisée par une étape de lithographie en niveau de gris dite Grayscale sur la couche de matériau de structuration suivie d'une étape de réticulation de la résine ; avantageusement, l'étape de structuration est suivie, avant l'étape de dépôt conforme de la première couche réfléchissante sur les au moins deux motifs de matériau de structuration, d'une étape de dépôt conforme d'une couche d'encapsulation sur les au moins deux motifs de matériau de structuration, ladite première couche réfléchissante recouvrant la couche d'encapsulation ;

- Selon un second mode de réalisation, ledit matériau de structuration est un matériau isolant organique ou inorganique, ladite étape de structuration comportant les sous-étapes suivantes :

    ◦ Dépôt d'une couche de résine suivant l'étape de dépôt de la couche de matériau isolant organique ou inorganique ;

    ◦ Lithographie en niveau de gris dite Grayscale sur la couche de résine de façon à structurer en trois dimensions la couche de résine pour obtenir au moins deux motifs de résine de hauteurs différentes ;

    ◦ Transfert des deux motifs de résine dans la couche de matériau organique ou inorganique de façon à obtenir lesdits au moins deux motifs de matériau de structuration de hauteurs différentes.

- le dépôt de la couche réalisée dans le matériau diélectrique destiné à former les motifs diélectriques des cavités de Fabry-Pérot et le dépôt d'une couche réalisée dans le même matériau diélectrique de façon à finaliser la formation des cavités de Fabry-Pérot sont des dépôts conformes ;

- l'étape de structuration en trois dimensions de la couche de matériau de structuration est une étape d'obtention d'au moins deux motifs de matériau de structuration de hauteurs différentes présentant un espace vide entre lesdits au moins deux motifs de structuration.

- Selon une première variante, le procédé selon l'invention comporte, après l'étape de dépôt conforme de la première couche réfléchissante et avant le dépôt de la couche réalisée dans le matériau diélectrique destiné à former les motifs diélectriques des cavités de Fabry-Pérot, les étapes suivantes :

  ∘ Dépôt d'une couche, dite couche d'isolation, ladite couche d'isolation recouvrant la totalité des motifs de matériau de structuration en présentant une surface supérieure dont chaque point est situé à une hauteur relativement au substrat porteur supérieure à la hauteur maximale de référence ;

  ∘ Dépôt d'une couche de résine au-dessus de ladite couche d'isolation ;

  ∘ Retrait de la résine afin de conserver la résine uniquement au-dessus du ou des espace(s) vide(s) entre les motifs de matériau de structuration et laisser la couche d'isolation apparente au-dessus des motifs de matériau de structuration ;

  ∘ Retrait du matériau de la couche d'isolation dans la zone apparente de la couche d'isolation ;

  ∘ Retrait de la résine restante afin de conserver des murs réalisés dans ledit matériau de la couche d'isolation entre les motifs de matériau de structuration.

- Selon une seconde variante, le procédé selon l'invention comporte, après l'étape de dépôt conforme de la première couche réfléchissante et avant le dépôt de la couche réalisée dans le matériau diélectrique destiné à former les motifs diélectriques des cavités de Fabry-Pérot, les étapes suivantes :

  ∘ Dépôt d'une couche de résine recouvrant la totalité des motifs de matériau de structuration en présentant une surface supérieure dont chaque point est situé à une hauteur relativement au substrat porteur supérieure à la hauteur maximale de référence ;

  ∘ Retrait de la résine entre les motifs de matériau de structuration afin de conserver la résine uniquement au-dessus des motifs de matériau de structuration ;

  ∘ Dépôt d'une couche, dite couche d'isolation, ladite couche d'isolation recouvrant la totalité des motifs de matériau de structuration recouvert de résine et remplissant les espaces entre lesdits motifs, en présentant une surface supérieure dont chaque point est situé à une hauteur relativement au substrat porteur supérieure à la hauteur maximale de référence ;

  ∘ Retrait du matériau de la couche d'isolation situé au-dessus des motifs de matériau de structuration et de la résine restante afin de conserver des murs réalisés dans ledit matériau de la couche d'isolation entre les motifs de matériau de structuration ;

- ledit matériau de la couche d'isolation peut être un matériau sacrificiel ; ledit procédé comportant alors les étapes suivantes :

  ∘ Dépôt d'une couche de résine sur la seconde couche réfléchissante ;

  ∘ Retrait de la résine dans les zones au-dessus du ou des espace(s) entre les motifs de matériau de structuration ;

  ∘ Retrait du matériau de la seconde couche réfléchissante, du matériau diélectrique destiné à former les motifs diélectriques des cavités de Fabry-Pérot et du matériau sacrificiel dans les zones au-dessus du ou des espace(s) entre les motifs de matériau de structuration de façon à former des murs de vide entre les motifs de matériau de structuration et entre les cavités de Fabry-Pérot les surplombant ;

  ∘ Retrait de la résine restante.

- ledit matériau de la couche d'isolation peut être aussi un matériau diélectrique à bas ou haut indice optique ; on entend par matériau à haut ou bas indice optique, un matériau présentant un indice de réfraction optique strictement inférieur ou strictement supérieur à l'indice de réfraction de la résine ou du matériau de la sous-couche et à l'indice de réfraction du matériau diélectrique destiné à former les motifs diélectriques des cavités de Fabry-Pérot ; ledit procédé comporte alors les étapes suivantes :

◦ Dépôt d'une couche de résine sur la seconde couche réfléchissante ;

◦ Retrait de la résine dans les zones au-dessus du ou des espace(s) entre les motifs de matériau de structuration ;

◦ Retrait du matériau de la seconde couche réfléchissante et du matériau diélectrique dans les zones non protégées par la résine restante de façon à accéder au matériau diélectrique à bas ou haut indice optique ;

◦ Dépôt d'une couche du matériau diélectrique à bas ou haut indice optique au-dessus de la résine restante et venant compléter le matériau diélectrique déjà présent entre les motifs de matériau de structuration de façon à combler le vide entre les cavités de Fabry-Pérot les surplombant ;

◦ Retrait de la résine et du matériau diélectrique à bas ou haut indice optique au-dessus des zones de résine en laissant le matériau à bas ou haut indice optique entre les motifs de matériau de structuration et entre les cavités de Fabry-Pérot les surplombant de façon à former des murs d'isolation diélectrique.

L'invention et ses différentes applications seront mieux comprises à la lecture de la description qui suit et à l'examen des figures qui l'accompagnent.

**BREVE DESCRIPTION DES FIGURES**

Les figures sont présentées à titre indicatif et nullement limitatif de l'invention.

- La [Fig. 1] illustre les différentes étapes du procédé selon un premier mode de réalisation de l'invention ;

- La [Fig. 2] illustre les différentes étapes du procédé selon un second mode de réalisation de l'invention ;

- Les [Fig.3], [Fig. 4], [Fig. 5], [Fig. 6], [Fig. 7], [Fig. 8] et [Fig. 9] illustrent les différentes étapes de deux variantes du procédé selon l'invention permettant d'assurant une isolation optique entre les pixels ainsi qu'entre le cavités de Fabry-Pérot.

**DESCRIPTION DETAILLEE**

Les figures sont présentées à titre indicatif et nullement limitatif de l'invention

Il convient de rappeler au préalable que, de façon générale et bien connue de l'homme du métier, un filtre de couleur de type métal/diélectrique réalisé à partir d'une cavité de Fabry-Pérot est obtenu en dimensionnant l'épaisseur de la couche diélectrique formée entre les deux couches métalliques. Si le filtrage de plusieurs couleurs est recherché sur un même composant, il est alors nécessaire d'être en mesure d'obtenir une épaisseur de diélectrique d'épaisseur variable sur ce même composant.

Ce dimensionnement est par exemple réalisé à l'aide d'un programme de calcul électromagnétique tel que le formalisme de transfert de matrices d'Abeles ou un calcul de diffraction pour les pixels dont la taille est proche de la longueur d'onde tel que le formalisme de la Méthode Modale par Expansion de Fourier ou l'analyse rigoureuse par ondes couplées (RCWA selon la terminologie anglaise).

Ces programmes de calcul permettent de déterminer les paramètres optimaux des empilements métal diélectrique pour chaque pixel. Le calcul prend notamment en compte les épaisseurs des couches de métal et de diélectrique ainsi que leurs indices, le spectre et la distribution angulaire de la lumière incidente. Par exemple, dans le cas des filtres de Fabry-Pérot, la longueur d'onde centrale du filtre est déterminée approximativement par la formule suivante :

$$\lambda_{res} = \frac{2hn.\cos\theta}{m - \frac{\phi_1 + \phi_2}{2\pi}}$$

où

- h est l'épaisseur de la cavité, c'est-à-dire approximativement l'épaisseur de la couche diélectrique

- m, nombre entier positif entre 1 et 10, est l'ordre de la cavité,

- n est l'indice effectif de la cavité, et

- φ1 et φ2 sont les déphasages à la réflexion sur les miroirs métalliques (déterminés par la nature des matériaux en jeu et la longueur d'onde considérée),

- 0 est l'angle d'incidence de la lumière incidente sur le filtre (compté à partir de la perpendiculaire à la surface du filtre).

Une fois l'ordre de la cavité choisi, l'angle d'attaque connu, l'indice et les déphasages connus, il ne reste plus alors qu'à déterminer une épaisseur approximative h pour que la cavité soit centrée sur une longueur d'onde particulière. Une fois la fonction de filtrage calculée pour chaque filtre et chaque longueur d'onde, les épaisseurs h des diélectriques sont alors ajustées en fonction des performances recherchées (recherche d'un bon rapport signal sur bruit, d'un maximum de transmission, etc.).

Une autre méthode plus empirique consiste à calculer, pour plusieurs épaisseurs h, la réponse de l'empilement et à choisir h tel que le pic de résonance du filtre ($\lambda$res) soit positionné conformément au cahier des charges.

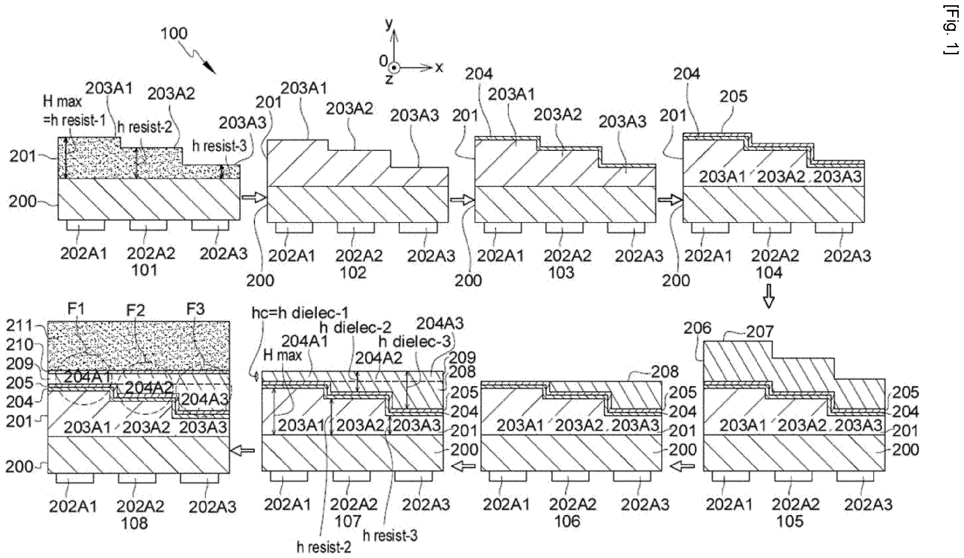

La [Fig. 1] illustre les différentes étapes d'un procédé 100 selon un premier mode de réalisation de l'invention dans lequel aucune isolation n'est prévue ni entre les cavités Fabry-Pérot ni entre les transducteurs photoélectriques.

La première étape 101 du procédé 100 consiste à déposer sur un substrat 200, dit substrat porteur, une couche de résine 201 puis à structurer en trois dimensions ladite couche de résine 201. Le substrat 200 peut par exemple être un substrat en Si, un substrat Silicium sur Isolant SOI (pour « Silicon On Insulator » selon la terminologie anglaise) ou un substrat en verre ou en saphir.

Le substrat porteur 200 comporte une pluralité de transducteurs (au moins deux) photoélectriques 202Ai (ici 3 transducteurs photoélectriques 202A1, 202A2, et 202A3 sont représentés). Les transducteurs 202Ai sont ici représentés de façon schématique sous le substrat 200, étant entendu qu'ils pourraient être formés à l'intérieur de ce dernier ou au-dessus de ce dernier. Selon l'invention, les transducteurs photoélectriques 202Ai sont considérés comme faisant partie intégrante du substrat porteur 200. Les transducteurs photoélectriques peuvent fonctionner soit en tant que collecteur de lumière issue des filtres soit en tant qu'émetteur de lumière vers les filtres. S'il s'agit de collecteurs, les transducteurs peuvent être par exemple des photodiodes de type CMOS. S'il s'agit d'émetteurs, les transducteurs peuvent être par exemple des diodes LED, des diodes de type QLED ou des diodes LASER, les émetteurs présentant dans ce cas un spectre d'émission plus large que celui des cavités de Fabry-Pérot correspondantes.

La structuration 3D de la couche de résine 201 est réalisée par une étape de lithographie. Cette lithographie peut être préférentiellement une lithographie en niveaux de gris ou Grayscale selon la terminologie anglaise électronique ou optique. D'autres techniques de lithographie telles que la lithographie à deux photons ou par nano-impression peuvent également être utilisées pour la réalisation de la structure en résine 201. La structure 201 comporte une pluralité de motifs 203Ai en 3D (ici 3 motifs 203A1, 203A2, et 203A3). Il est possible de fixer librement les dimensions de chaque motif dans les trois directions de l'espace Oxyz (où Oxy est le plan de la figure, l'axe Oy étant selon la direction perpendiculaire au plan du substrat 200 et l'axe Oz étant selon la direction perpendiculaire au plan de la figure).

Selon l'invention, il convient d'avoir au moins deux motifs 203Ai de résine de hauteurs différentes (ici les 3 motifs ont chacun des hauteurs différentes). Parmi l'ensemble de ces motifs 203Ai, l'un d'eux, ici le motif 203A1, présente une hauteur maximale Hmax, dite de référence, la hauteur étant mesurée perpendiculairement au plan du substrat 200 suivant l'axe Ox. De façon plus générale, la hauteur du motif 203Ai sera noté $h_{resist-i}$. Ainsi, sur la figure 1, Hmax est égal à $h_{resist-1}$. Chaque motif 203Ai est en regard selon l'axe Oy du transducteur 202Ai correspondant.

Le procédé 100 comporte ensuite une étape 102 de réticulation (« cross linking » selon la terminologie anglaise) de la couche de résine structurée 201 afin de densifier cette dernière via une stabilisation de la résine Grayscale par procédé thermique ou ultraviolet.

Avantageusement, le procédé 100 selon l'invention comporte une troisième étape 103 consistant à réaliser un dépôt conforme d'une couche fine d'encapsulation 204 (quelques dizaines de nm) sur les motifs de résine 203Ai (au-dessus et sur les flancs des motifs 203Ai). Le matériau de la couche d'encapsulation 204 peut être par exemple un oxyde de type Al2O3 ou SiO2 ou un nitrure et le dépôt sera préférentiellement réalisé par une technique de dépôt basse température tel qu'un dépôt par couches atomiques ALD (« Atomic Layer Déposition » selon la terminologie anglaise).

Le procédé 100 selon l'invention comporte alors une étape 104 de dépôt d'une couche réfléchissante 205, par exemple d'une épaisseur comprise entre 20 et 100 nm, recouvrant la couche d'encapsulation 204 au-dessus des motifs de résine 203Ai. Cette couche réfléchissante 205, typiquement une couche métallique, forme la première couche réfléchissante des filtres de couleurs de type cavité de Fabry-Pérot à venir. La couche réfléchissante 205 est déposée de façon conforme par dépôt chimique par phase vapeur CVD (Chemical Vapor Déposition en anglais) ou dépôt physique par phase vapeur PVD (Physical Vapor Déposition). La couche 205 est déposée en continue sur l'ensemble des motifs de résine 203Ai recouvert de la couche d'encapsulation, y-compris sur les flancs de ces derniers. Le dépôt conforme permet d'avoir une épaisseur de la couche réfléchissante 205 constante, a minima sur le dessus des motifs mais également préférentiellement sur les flancs des motifs 203Ai.

L'étape suivante 105 consiste à déposer une couche 206 réalisée dans le matériau diélectrique destiné à former les motifs diélectriques des cavités de Fabry-Pérot. La couche 206 de matériau diélectrique recouvre la totalité des motifs de résine 203Ai recouvertes des couches d'encapsulation 204 et réfléchissante 205. La couche 206 présente une surface supérieure 207 (non nécessairement plane) dont chaque point est situé à une hauteur, relativement au substrat porteur 200, supérieure à la hauteur maximale de référence Hmax. Le matériau de la couche 206 est préférentiellement mais non limitativement un matériau transparent dans le domaine du visible tel qu'un matériau organique du type polymère ou inorganique (oxyde, nitrure de silicium, alumine, ...). Le dépôt est préférentiellement un dépôt conforme par exemple réalisé par une technique de dépôt physique par phase vapeur PVD (Physical Vapor Déposition) ou de dépôt chimique par phase vapeur CVD (Chemical Vapor Déposition en anglais) ou de dépôt chimique par phase vapeur à basse pression LPCVD (Low Pressure Chemical Vapor Déposition en anglais) ou de dépôt chimique par phase vapeur assisté par plasma PECVD (Plasma Enhanced Chemical Vapor Déposition en anglais). Il convient de noter que l'invention ne se limite pas au domaine du visible et que d'autres matériaux transparents à d'autres longueurs d'onde, dans l'infrarouge par exemple (par exemple en utilisant du silicium), peuvent être utilisés.

Le procédé 100 comporte alors une étape 106 de planarisation de la couche 206 réalisée dans le matériau diélectrique destiné à former les motifs diélectriques des cavités de Fabry-Pérot de façon à former une couche 208 planarisée en surface par retrait du matériau diélectrique de la couche 206. L'étape de planarisation peut être réalisée par une étape de gravure de type etch-back éventuellement et/ou une étape de polissage mécano-chimique CMP (Chemical Mechanical Polishing selon la terminologie anglaise). La planarisation s'effectue avec arrêt sur la couche réfléchissante 205 située à son niveau le plus haut (i.e. au niveau de la hauteur de référence du motif 203A1).

Le procédé 100 selon l'invention comporte ensuite une étape 107 de dépôt conforme d'une couche 209 du même matériau diélectrique destiné à former les motifs diélectriques des cavités de Fabry-Pérot que lors de l'étape 105. Cette étape est par exemple réalisée par une technique de dépôt physique par phase vapeur PVD (Physical Vapor Déposition) ou de dépôt chimique par phase vapeur CVD (Chemical Vapor Déposition en anglais) ou de dépôt chimique par phase vapeur à basse pression LPCVD (Low Pressure Chemical Vapor Déposition en anglais) ou de dépôt chimique par phase vapeur assisté par plasma PECVD (Plasma Enhanced Chemical Vapor Déposition en anglais). La hauteur de la couche 209 est notée hc, la hauteur étant mesurée perpendiculairement au plan du substrat. Après cette étape, on obtient une pluralité de motifs diélectriques de cavité de Fabry-Pérot 204Ai (ici trois motifs 204A1, 204A2 et 204A3).

Pour chaque motif de résine 204Ai, on note hdiel_i la hauteur du motif, la hauteur étant mesurée perpendiculairement au plan du substrat. La hauteur hdiel_i du motif 204i peut être déterminée selon les méthodes mentionnées plus haut (en fonction du cahier des charges pour le filtrage recherché). Selon le procédé 100 selon l'invention, on fixe la hauteur hdiel_i par la formule suivante : hdiel_i = Hmax - $h_{resist-i}$ + hc.

Ainsi, pour le motif 204A1, hdiel_1 est ici directement égale à la hauteur hc de la couche 209.

De façon plus générale, pour chaque motif 204Ai, la hauteur est déterminée technologiquement par la différence de hauteur entre celle du motif de résine 203A1 le plus haut Hmax et la hauteur du motif de résine 203Ai à laquelle on ajoute la hauteur de la seconde couche 209 de diélectrique. On observe ainsi que la hauteur des motifs diélectriques de cavité de Fabry-Pérot 204Ai n'est pas liée à l'épaisseur de la couche de résine 201 (contrairement aux solutions de l'état de la technique qui rendent difficile l'obtention d'épaisseur d'une dizaine de nm) mais à la différence de hauteur entre les motifs. Une telle configuration permet d'atteindre des hauteurs beaucoup plus petites. Ceci est particulièrement vrai pour le motif diélectrique de cavité de Fabry-Pérot 204A1 formé directement au-dessus du motif de résine le plus haut 203A1 qui ne dépend que de la hauteur de la seconde couche 209 de diélectrique très facilement contrôlable et qui peut atteindre des valeurs de l'ordre de 10 nm.

L'étape 108 du procédé 100 consiste alors à déposer une second couche réfléchissante 210, par exemple d'une épaisseur comprise entre 20 et 50 nm, recouvrant la seconde couche de diélectrique 209 au-dessus des motifs de cavités de Fabry-Pérot 204Ai. Cette couche réfléchissante 210 plane forme la seconde couche réfléchissante des filtres de couleurs de type cavité de Fabry-Pérot. La couche réfléchissante 210 est déposée de façon conforme par dépôt chimique par phase vapeur CVD (Chemical Vapor Déposition en anglais) ou dépôt physique par phase vapeur PVD (Physical Vapor Déposition). On obtient ainsi une pluralité (ici 3) de filtres Fi (i.e. F1, F2 et F3) de couleurs de type cavité de Fabry-Pérot formé chacun par la première couche réfléchissante 205, le motif 204Ai et la seconde couche réfléchissante 210.

De façon optionnelle, il est également possible de déposer une couche 211 selon la technologie CMOS sur la seconde couche réfléchissante 210.

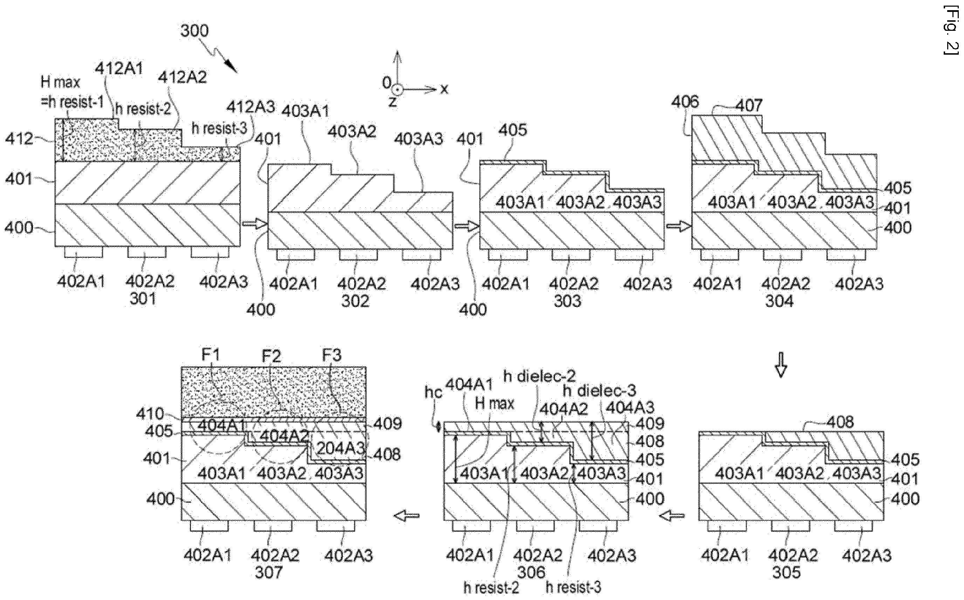

La [Fig. 2] illustre les différentes étapes d'un procédé 300, alternative au procédé 100 de la figure 1, dans lequel aucune isolation n'est prévue ni entre les cavités Fabry-Pérot ni entre les transducteurs photoélectriques.

La première étape 301 du procédé 300 consiste à déposer sur un substrat 400, dit substrat porteur, une couche de matériau tel qu'un matériau organique du type polymère ou inorganique (oxyde, nitrure de silicium, alumine, ...)., dite sous-couche 401. Le substrat 400 est du même type que le substrat 200 de la figure 1 et comporte une pluralité de transducteurs (au moins deux) photoélectriques 402Ai (ici 3 transducteurs photoélectriques 402A1, 402A2, et 402A3 sont représentés). Une couche de résine 412 est ensuite déposée sur la sous-couche 401. La couche de résine 412 est alors structurée en trois dimensions. La structuration 3D de la couche de résine 412 est réalisée par une étape de lithographie. Cette lithographie peut être préférentiellement une lithographie en niveaux de gris ou Grayscale selon la terminologie anglaise électronique ou optique. D'autres techniques de lithographie telles que la lithographie à deux photons ou par nano-impression peuvent également être utilisées pour la réalisation de la structure en résine 412. La structure 412 comporte une pluralité de motifs 412Ai en 3D (ici 3 motifs 412A1, 412A2, et 412A3). Il est possible de fixer librement les dimensions de chaque motif dans les trois directions de l'espace Oxyz (où Oxy est le plan de la figure, l'axe Oy étant selon la direction perpendiculaire au plan du substrat 400 et l'axe Oz étant selon la direction perpendiculaire au plan de la figure).

Selon l'invention, il convient d'avoir au moins deux motifs 412Ai de résine de hauteurs différentes (ici les 3 motifs ont chacun des hauteurs différentes). Parmi l'ensemble de ces motifs 412Ai, l'un d'eux, ici le motif 412A1, présente une hauteur maximale Hmax, dite de référence, la hauteur étant mesurée perpendiculairement au plan du substrat 400 suivant l'axe Ox. De façon plus générale, la hauteur du motif 412Ai sera noté $h_{resist-i}$. Ainsi, sur la figure 2, Hmax est égal à $h_{resist-1}$. Chaque motif 412Ai est en regard selon l'axe Oy du transducteur 202Ai correspondant.

Le procédé 300 comporte alors une étape 302 de transfert des motifs 412Ai de la couche de résine structurée 412 dans la sous-couche 401 : en d'autres termes, à l'issue de cette étape 302, la couche de résine structurée 412 est retirée et entièrement transférée dans la sous-couche 401 de sorte que la sous-couche 401 est elle-même structurée en trois dimensions avec une pluralité de motifs 403Ai (ici trois motifs 403A1, 403A2 et 403A3) de dimensions semblables aux dimensions des motifs 412Ai. Cette étape de transfert peut être réalisée selon des techniques connues de la personne du métier telles qu'une gravure sèche ou une gravure humide.

L'étape 302 est suivie d'une étape 303 de dépôt d'une couche réfléchissante 405, par exemple d'une épaisseur comprise entre 20 et 50 nm, recouvrant les motifs 403Ai de la sous-couche structurée 401. Cette couche réfléchissante 505 forme la première couche réfléchissante des filtres de couleurs de type cavité de Fabry-Pérot à venir. La couche réfléchissante 505 est déposée de façon conforme par dépôt chimique par phase vapeur CVD (Chemical Vapor Déposition en anglais) ou dépôt physique par phase vapeur PVD (Physical Vapor Déposition). La couche 405 est déposée en continue sur l'ensemble des motifs 403Ai, y-compris sur les flancs de ces derniers. Le dépôt conforme permet d'avoir une épaisseur de la couche réfléchissante 405 constante, a minima sur le dessus des motifs mais également préférentiellement sur les flancs des motifs 403Ai. On notera que, contrairement au premier mode de réalisation de la figure 1, il est ici tout à fait possible de s'affranchir du dépôt d'une couche d'encapsulation. Comme pour le premier mode de réalisation de la figure 1, l'étape de structuration, utilisant par exemple la lithographie Grayscale est réalisée avant l'étape de dépôt de la première couche métallique réfléchissante.

L'intérêt d'avoir des motifs qui ne sont pas en résine mais dans un autre matériau organique ou inorganique réside dans le fait que la résine est souvent une résine polymère qui peut présenter des caractéristiques qui se dégradent dans le temps entraînant un changement de couleur ou des pertes de transmission de lumière. L'utilisation d'un matériau organique permet d'avoir une meilleure stabilité dans le temps et l'utilisation d'un matériau organique permet d'éviter une évolution de la couleur dans le temps.

Les étapes 304 à 307 du procédé 300 selon l'invention sont identiques aux étapes 105 à 108 du procédé 100 selon l'invention.

Ainsi, l'étape suivante 304 consiste à déposer une couche 406 réalisée dans le matériau diélectrique destiné à former les motifs diélectriques des cavités de Fabry-Pérot. La couche 406 de matériau diélectrique recouvre la totalité des motifs 403Ai recouvertes de la couche réfléchissante 405. La couche 406 présente une surface supérieure 407 (non nécessairement plane) dont chaque point est situé à une hauteur, relativement au substrat porteur 400, supérieure à la hauteur maximale de référence Hmax. Le matériau de la couche 406 est préférentiellement mais non limitativement un matériau transparent dans le domaine du visible tel qu'un matériau organique du type polymère ou inorganique (oxyde, nitrure de silicium, alumine, ...). Le dépôt est préférentiellement un dépôt conforme par exemple réalisé par une technique de dépôt physique par phase vapeur PVD (Physical Vapor Déposition) ou de dépôt chimique par phase vapeur CVD (Chemical Vapor Déposition en anglais) ou de dépôt chimique par phase vapeur à basse pression LPCVD (Low Pressure Chemical Vapor Déposition en anglais) ou de dépôt chimique par phase vapeur assisté par plasma PECVD (Plasma Enhanced Chemical Vapor Déposition en anglais).

Le procédé 400 comporte alors une étape 305 de planarisation de la couche 406 réalisée dans le matériau diélectrique destiné à former les motifs diélectriques des cavités de Fabry-Pérot de façon à former une couche 408 planarisée en surface par retrait du matériau diélectrique de la couche 406. La planarisation s'effectue avec arrêt sur la couche réfléchissante 405 située à son niveau le plus haut (i.e. au niveau de la hauteur de référence du motif 403A1).

Le procédé 300 selon l'invention comporte ensuite une étape 306 de dépôt conforme d'une couche 409 du même matériau diélectrique destiné à former les motifs diélectriques des cavités de Fabry-Pérot que lors de l'étape 304. Cette étape est par exemple réalisée par une technique de dépôt PVD, CVD, LPCVD ou PECVD. La hauteur de la couche 409 est notée hc, la hauteur étant mesurée perpendiculairement au plan du substrat. Après cette étape, on obtient une pluralité de motifs diélectriques de cavité de Fabry-Pérot 404Ai (ici trois motifs 404A1, 404A2 et 404A3).

Pour chaque motif de résine 404Ai, sa hauteur hdiel_i est déterminée de façon identique à cas du procédé 100 de la figure 1.

L'étape 307 du procédé 300 consiste alors à déposer une second couche réfléchissante 410, par exemple d'une épaisseur comprise entre 20 et 50 nm, recouvrant la seconde couche de diélectrique 409 au-dessus des motifs de cavités de Fabry-Pérot 404Ai. Cette couche réfléchissante 410 plane forme la seconde couche réfléchissante des filtres de couleurs de type cavité de Fabry-Pérot. La couche réfléchissante 410 est déposée de façon conforme par dépôt CVD ou PVD. On obtient ainsi une pluralité (ici 3) de filtres Fi (i.e. F1, F2 et F3) de couleurs de type cavité de Fabry-Pérot formé chacun par la première couche réfléchissante 405, le motif 404Ai et la seconde couche réfléchissante 410.

De façon optionnelle, il est également possible de déposer une couche 411 CMOS sur la seconde couche réfléchissante 410.

Les modes de réalisation des figures 1 et 2 illustrent la fabrication simple et efficace de cavités résonnantes de Fabry-Pérot. Toutefois, dans le cas de transducteurs photoélectriques présents de façon discrète, c'est-à-dire des transducteurs pixélisés, chaque pixel étant formé par un transducteur photoélectrique (un photodétecteur par exemple) et la cavité de Fabry-Pérot correspondante, il peut être particulièrement intéressant de réaliser une isolation optique entre chaque pixel. En effet, lorsque les dimensions des pixels et donc des filtres de couleur se réduisent, typiquement de l'ordre de la longueur d'onde de la lumière, le recouvrement spatial des contributions lumineuses d'une cavité de Fabry-Pérot à l'autre, peut dégrader l'efficacité du dispositif global. Ce phénomène de « crosstalk » a déjà été observé pour les transducteurs photoélectriques (i.e. les capteurs CMOS). Au cours des dernières années, les dimensions des pixels n'ont en effet cessé de se réduire, ceci afin de proposer des capteurs à haute résolution, pour les Smartphones notamment. Cette réduction de dimensions des pixels a deux conséquences bien distinctes :

- La quantité totale de lumière incidente arrivant sur chaque pixel décroit, impliquant que de moins en moins de photons atteignent le composant photosensible. La collection et le bon guidage de chaque photon au sein du composant vers le capteur est d'autant plus importante pour garantir la bonne l'efficacité du capteur.

- Lorsque la taille du pixel se rapproche de la longueur de la lumière à collecter, la diffraction entre en jeu, ce qui accroit les pertes optiques et spatiales dans le dispositif.

Accompagnant les problématiques liées à la réduction des dimensions des pixels, l'angle d'incidence avec lequel la lumière pénètre dans la cavité de Fabry-Pérot est également un élément à ne pas négliger. En effet, lorsque des rayons lumineux obliques atteignent la surface des cavités, une certaine partie de la lumière passe à travers la bordure physique du filtre, pour venir terminer sa course dans la cavité voisine. Cette contribution indésirable, parasite, fausse la collection de lumière à l'échelle du dispositif, et est une autre source importante dans le « crosstalk » d'un pixel à l'autre.

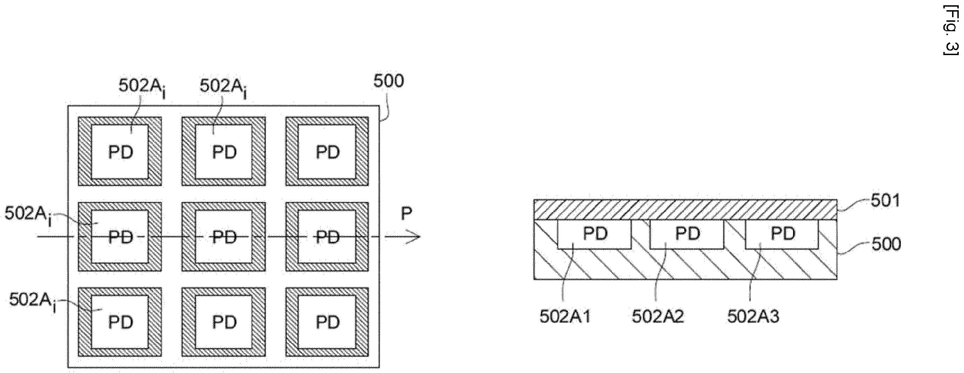

La figure 3 montre schématiquement un substrat porteur 500 en vue de dessus et en coupe selon le plan P perpendiculaire au plan du substrat 500 et coupant les transducteurs photoélectriques. Le substrat porteur 500 comporte une pluralité de transducteurs photoélectriques 502Ai pixélisés disposés sous la forme d'une matrice (ici une matrice 3x3) dans le substrat 500 (dont trois 502A1, 502A3 et 502A3 sont représentés en coupe) inclus dans le substrat 500. Le substrat 500 est recouvert d'une couche barrière 501.

Nous allons maintenant décrire différentes variantes du procédé selon l'invention permettant de réaliser des filtres de couleurs, chacun associé à un transducteur localisé au-dessus ou dans le substrat 500, avec une isolation optique permettant de réduire le cross-talk, non seulement entre les transducteurs photoélectriques pixélisés mais aussi entre les cavités de Fabry-Pérot.

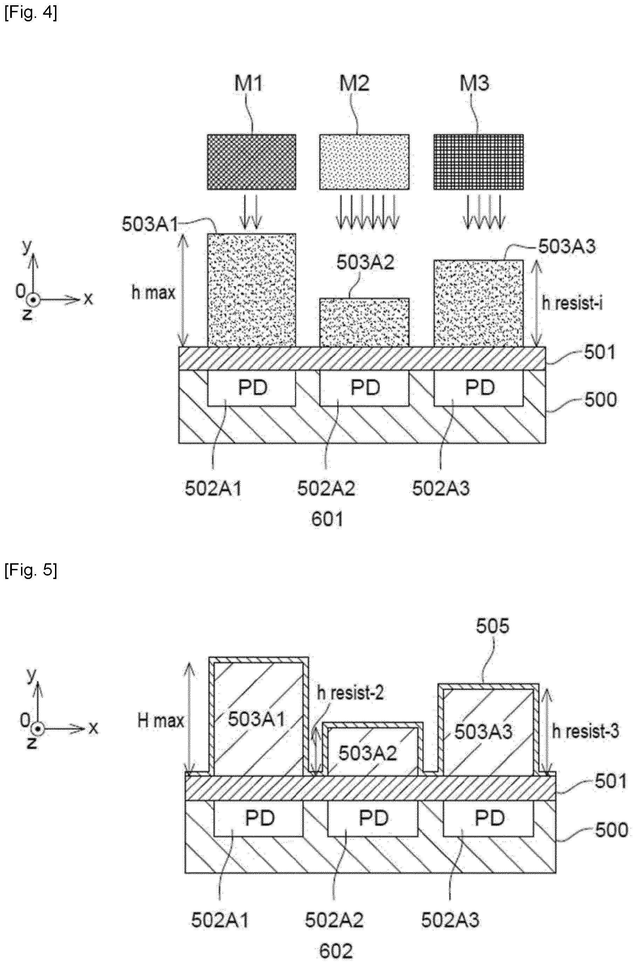

La première étape 601 illustrée en figure 4 et commune à ces variantes consiste à réaliser des motifs de résine 503Ai de hauteur différente, appelés par la suite piliers (ici trois piliers 503A1, 503A2 et 503A3), au-dessus de la couche barrière 501, étant entendu que ces piliers pourraient être réalisés directement sur le substrat 500. Pour ce faire, on commence par déposer une couche de résine qui est ensuite structurée en trois dimensions par lithographie Grayscale en utilisant des masques M1, M2 et M3 de densités différentes. L'exposition de la résine est ainsi différente et on obtient, après développement, les trois piliers 503Ai de hauteur différente, la résine entre les piliers étant entièrement retirée de sorte qu'il existe un espace vide entre chaque pilier 503Ai.

Comme dans le cas des figures 1 et 2, il convient d'avoir au moins deux piliers 503Ai de résine de hauteurs différentes (ici les 3 piliers ont chacun des hauteurs différentes). Parmi l'ensemble de ces piliers 503Ai, l'un d'eux, ici le pilier 503A1, présente une hauteur maximale Hmax, dite de référence, la hauteur étant mesurée perpendiculairement au plan du substrat 500 suivant l'axe Ox. De façon plus générale, la hauteur du pilier 503Ai sera noté $h_{resist-i}$. Ainsi, sur la figure , Hmax est égal à $h_{resist\_1}$. Chaque pilier 503Ai est en regard selon l'axe Oy du transducteur 502Ai correspondant. Comme dans le cas de la figure 1, les piliers de résine 503i sont réticulés afin de les densifier.

On notera que les piliers 502Ai de la figure 4 sont en résine mais qu'ils pourraient également être réalisés dans un matériau organique ou inorganique au moyen d'une sous-couche telle que présentée en référence à la figure 2 par transfert de motifs de résine dans la sous-couche.

L'étape suivante 602 illustrée en figure 5 est également commune à ces variantes du procédé selon l'invention et correspond aux étapes 103-104 et 303 des figures 1 et 2. Il s'agit en effet soit de déposer une couche d'encapsulation puis une couche réfléchissante sur les piliers 502Ai lorsque ces derniers sont en résine ou simplement une couche réfléchissante sur les piliers 502Ai lorsque ces derniers sont en matériau organique ou inorganique. Par souci de simplification, la couche d'encapsulation et la couche réfléchissante (cas de piliers de résine) ou la couche réfléchissante (cas des piliers de la sous-couche) sont représentées par une seule et même couche 505 sur la figure 5 désignée par la suite par le terme générique « couche réfléchissante ». Les techniques de réalisation de cette couche sont semblables à celles déjà présentées en référence aux figures 1 et 2. L'épaisseur de la couche réfléchissante varie entre une dizaine de nanomètres et quelques centaines de nanomètres en fonction du métal choisi et des choix de design.

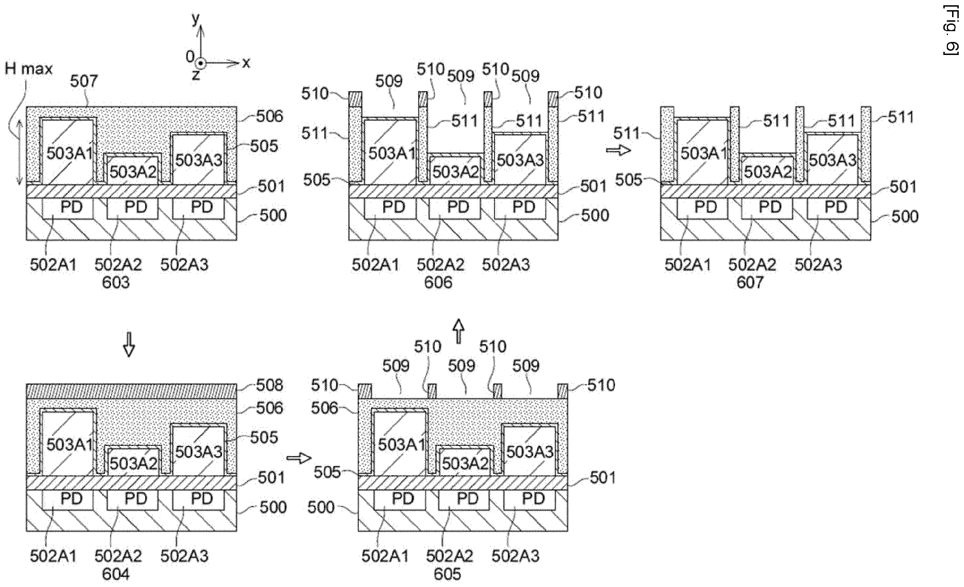

La figure 6 illustre les étapes 603 à 607 d'une première variante de réalisation d'une isolation optique entre les pixels adjacents (i.e. entre les transducteurs photoélectriques 502Ai et entre les piliers 503Ai de résine ou de matériau de sous-couche).

L'étape 603 consiste à déposer une couche, dite couche d'isolation 506. Cette couche d'isolation sensiblement plane recouvre la totalité des piliers 503Ai recouvert de la couche réfléchissante 505 et présente une surface supérieure 507 dont chaque point est situé à une hauteur relativement au substrat porteur supérieure à la hauteur maximale de référence Hmax. Comme nous le verrons par la suite, la couche d'isolation 506 peut être réalisée dans un matériau sacrificiel (i.e. destiné à disparaître) ou au contraire dans un matériau à haut indice optique ou bas indice optique destiné à assurer l'isolation entre les transducteurs photoélectriques 502Ai. On entend par matériau à haut ou bas indice optique, un matériau présentant un indice de réfraction optique strictement inférieur ou strictement supérieur à l'indice de réfraction de la résine ou du matériau de la sous-couche et à l'indice de réfraction du matériau diélectrique destiné à former les motifs diélectriques des cavités de Fabry-Pérot.

On pourra utiliser pour les matériaux à haut indice optique un matériau tel que du SiN et pour les matériaux à bas indice optique des polymères qui présentent des groupements fluorés. Nous verrons pas la suite que lorsque le matériau utilisé est un matériau sacrificiel, l'objectif est alors de créer des tranchées d'air (« airgap » selon la terminologie anglaise) pour réaliser l'isolation.

L'étape 604 consiste à déposer une couche de résine photosensible ou électrosensible 508 au-dessus de la couche d'isolation 506.

L'étape 605 consiste alors à réaliser des tranchées 509 alignées avec les bordures des piliers 503Ai. Pour ce faire, la couche de résine photo ou électrosensible 508 est exposée à l'aide d'un équipement de lithographie, afin de définir à sa surface un quadrillage régulier de tranchée après développement de la résine. La lithographie utilisée ici est un lithographie classique. Les tranchées 509 sont créées après retrait de la résine laissant des lignes de résine 510 au-dessus de la couche 506 de matériau d'isolation dans la zone située entre chaque pilier 503Ai.

Selon l'étape 606, dans les espaces ouverts dans la résine formés par les tranchées 509, on grave par ailleurs le matériau d'isolation avec arrêt sur la couche réfléchissante 505. A l'issue de cette étape 606, il reste sur les bords respectifs de chaque piliers 503Ai des bordures ou murs 511 de matériau d'isolation, chaque bordure 511 étant prolongée par une ligne de résine 510.

L'étape suivante 607 consiste alors à retirer (par une technologie de type gravure ou stripping selon la terminologie anglaise) les lignes de résine 510 de façon à ne laisser que les bordures ou murs 511 de matériau d'isolation de chaque côté des piliers 503Ai remplissant l'espace vide entre les piliers 503Ai. Les murs 511 peuvent agir en tant qu'isolant optique entre les pixels adjacents. Ils peuvent également agir en tant que murs de confinement pour les piliers de résine ou de matériau de sous-couche. Les murs permettront également d'éviter la déformation des piliers de résine ou de matériau de sous-couche lors de l'étape de planarisation à venir.

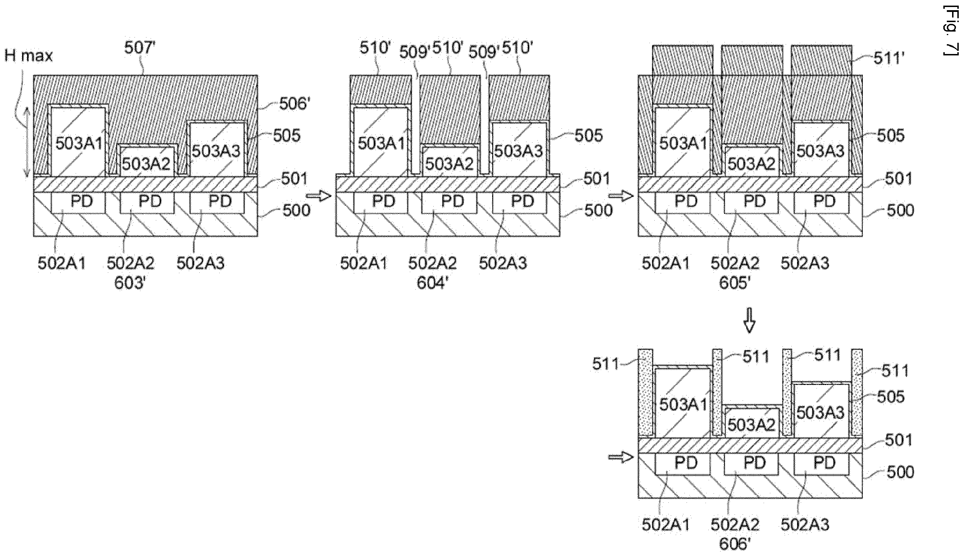

La figure 7 illustre les étapes 603' à 606' d'une seconde variante de réalisation d'une isolation optique entre les pixels adjacents (i.e. entre les transducteurs photoélectriques 502Ai et entre les motifs 503Ai de résine ou de matériau de sous-couche).

L'étape 603' consiste à déposer une couche de résine 506' photo ou électrosensible. Cette couche de résine 506' recouvre la totalité des piliers 503Ai recouvert de la couche réfléchissante 505 et présente une surface supérieure 507' dont chaque point est situé à une hauteur relativement au substrat porteur supérieure à la hauteur maximale de référence Hmax.

L'étape 604' consiste alors à réaliser des tranchées 509' créant des espaces vides entre chaque piliers 503Ai. Pour ce faire, la couche de résine photo ou électrosensible 507' est exposée à l'aide d'un équipement de lithographie, afin de définir à sa surface un quadrillage régulier de tranchée après développement de la résine. La lithographie utilisée ici est un lithographie classique. Les tranchées 509' sont créées après retrait de la résine laissant de la résine 510' au-dessus de chaque pilier 503Ai.

Selon l'étape suivante 605', on dépose une couche, dite couche d'isolation 511'. Cette couche d'isolation 511' recouvre la totalité de la résine 510' et remplit les tranchées 509' sur une hauteur strictement supérieure à Hmax. Comme dans le cas de la figure 6, la couche d'isolation 511' peut être réalisée dans un matériau sacrificiel (i.e. destiné à disparaître) ou au contraire dans un matériau à haut indice optique ou bas indice optique destiné à assurer l'isolation entre les transducteurs photoélectriques 502Ai.

L'étape 606' consiste alors à retirer la résine 510' ainsi que le matériau de la couche d'isolation 511' localisé au-dessus de la résine 510', par exemple par des techniques de gravure ou de stripping selon la terminologie anglaise de façon à ne laisser que des murs 511 de matériau d'isolation de chaque côté des piliers 503Ai remplissant l'espace vide entre lesdits piliers 503Ai. On constate que la structure obtenue après les étapes 603' à 606' de la figure 7 est identique à celle obtenue après les étapes 603 à 607 de la figure 6.

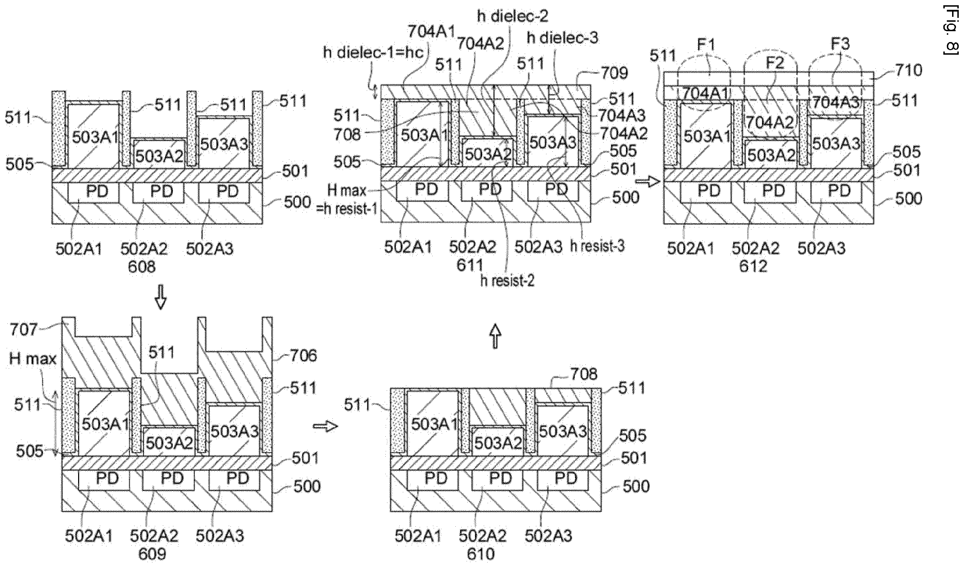

Partant de la structure obtenu à l'issue de l'étape 607 de la figure 6 ou de l'étape 606' de la figure 7, la figure 8 illustre les étapes 608 à 612 permettant de réaliser les cavités de Fabry-Pérot. On notera que ces étapes 609 à 612 sont sensiblement les mêmes que les étapes 105 à 108 et 304 à 307 des figures 1 et 2.

L'étape 608 consiste ainsi à partir de la structure obtenu à l'issue de l'étape 607 de la figure 6 ou de l'étape 606' de la figure 7.

L'étape suivante 609 consiste à déposer une couche 706 réalisée dans le matériau diélectrique destiné à former les motifs diélectriques des cavités de Fabry-Pérot. La couche 706 de matériau diélectrique recouvre la totalité des piliers 503Ai recouvertes de la couche réfléchissante 505. La couche 706 présente une surface supérieure 707 (non nécessairement plane) dont chaque point est situé à une hauteur, relativement au substrat porteur 500, supérieure à la hauteur maximale de référence Hmax. Le matériau de la couche 706 est préférentiellement mais non limitativement un matériau transparent dans le domaine du visible tel qu'un matériau organique du type polymère ou inorganique (oxyde, nitrure de silicium, alumine, ...). Le dépôt est préférentiellement un dépôt conforme par exemple réalisé par une technique de dépôt PVD, CVD, LPCVD ou PECVD.

Le procédé comporte alors une étape 610 de planarisation de la couche 706 réalisée dans le matériau diélectrique destiné à former les motifs diélectriques des cavités de Fabry-Pérot de façon à former une couche 708 planarisée en surface par retrait du matériau diélectrique de la couche 706. La planarisation s'effectue avec arrêt sur la couche réfléchissante 505 située à son niveau le plus haut (i.e. au niveau de la hauteur de référence du pilier 503A1).

Le procédé selon l'invention comporte ensuite une étape 611 de dépôt conforme d'une couche 709 du même matériau diélectrique destiné à former les motifs diélectriques des cavités de Fabry-Pérot que lors de l'étape 609. La hauteur de la couche 709 est notée hc, la hauteur étant mesurée perpendiculairement au plan du substrat. Après cette étape, on obtient une pluralité de motifs diélectriques de cavité de Fabry-Pérot 704Ai (ici trois motifs 704A1, 704A2 et 704A3).

Pour chaque motif diélectrique 704Ai, on note hdiel_i la hauteur du motif, la hauteur étant mesurée perpendiculairement au plan du substrat. La hauteur hdiel_i du motif 704i peut être déterminée selon les méthodes mentionnées plus haut. Selon le procédé selon l'invention, on fixe la hauteur hdiel_i par la formule suivante : hdiel_i = Hmax - $h_{resist\text{-}i}$ + hc.

Ainsi, pour le motif 704A1, hdiel_1 est ici directement égale à la hauteur hc de la couche 709.

De façon plus générale, pour chaque motif 704Ai, la hauteur est déterminée technologiquement par la différence de hauteur entre celle du motif de résine 503A1 le plus haut Hmax et la hauteur du motif de résine 503Ai à laquelle on ajoute la hauteur de la seconde couche 709 de diélectrique.

L'étape 612 du procédé selon l'invention consiste alors à déposer une seconde couche réfléchissante 710, par exemple d'une épaisseur comprise entre 20 et 50 nm, recouvrant la seconde couche de diélectrique 709 au-dessus des motifs de cavités de Fabry-Pérot 704Ai. Cette couche réfléchissante 710 plane forme la seconde couche réfléchissante des filtres de couleurs de type cavité de Fabry-Pérot. La couche réfléchissante 710 est déposée de façon conforme. On obtient ainsi une pluralité (ici 3) de filtres Fi (i.e. F1, F2 et F3) de couleurs de type cavité de Fabry-Pérot formé chacun par la première couche réfléchissante 505, le motif 704Ai et la seconde couche réfléchissante 710. On notera qu'à ce stade, les transducteurs photoélectriques 502Ai ainsi que les piliers 503Ai sont bien isolés par les murs 511 mais que les motifs diélectriques 704Ai et donc les cavités de Fabry-Pérot ne le sont pas totalement.

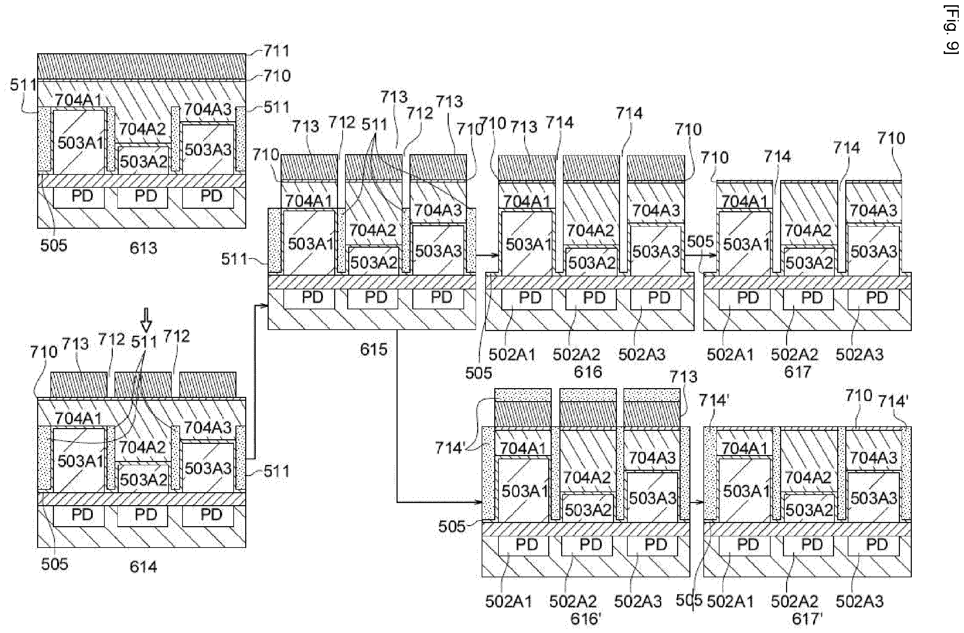

La figure 9 illustre deux variantes de réalisation d'une isolation visant à réduire le cross-talk non seulement entre les transducteurs photoélectriques 502Ai ainsi que les piliers 503Ai mais aussi entre les motifs diélectriques 704Ai et donc les cavités de Fabry-Pérot.

En partant de la structure obtenue à l'issue de l'étape 612 de la figure 8, l'étape 613 consiste à déposer une couche de résine 711 sur la seconde couche réfléchissante 711.

L'étape 614 consiste alors à réaliser des tranchées 712 alignées avec les murs 511. Pour ce faire, la couche de résine photo ou électrosensible 711 est exposée à l'aide d'un équipement de lithographie, afin de définir à sa surface un quadrillage régulier de tranchée après développement de la résine. La lithographie utilisée ici est un lithographie classique. Les tranchées 712 sont créées après retrait de la résine laissant des lignes de résine 713 au-dessus de la seconde couche réfléchissante 710 dans la zone située au-dessus de chaque pilier 503Ai.

Selon l'étape 615, dans les espaces ouverts dans la résine formés par les tranchées 712, on grave par ailleurs le métal de la seconde couche réfléchissante 710 ainsi que le matériau diélectrique utilisé pour les cavités de Fabry-Pérot de façon à accéder aux murs 511.

Le procédé peut alors prendre deux voies différentes selon que le matériau des murs 511 est un matériau sacrificiel ou un matériau à haut indice optique ou bas indice optique destiné à assurer une isolation optique.

Selon une première variante dans laquelle le matériau des murs 511 est un matériau sacrificiel, le procédé comporte une étape 616 de retrait des murs 511 de façon à former des tranchées d'air 714 (« air-gap » selon la terminologie anglaise) isolant complètement entre eux les transducteurs photoélectriques 502Ai, les piliers 503Ai et les motifs diélectriques 704Ai et donc les cavités de Fabry-Pérot.

L'étape 617 consiste enfin à retirer par stripping ou gravure la résine 713 restante.

Selon une seconde variante dans laquelle le matériau des murs 511 est un matériau à haut ou bas indice optique, le procédé comporte une étape 616' de de dépôt d'une couche 714' dudit matériau à haut ou bas indice de réfraction de façon à former des murs réalisés dans ce matériau isolant complètement les transducteurs photoélectriques 502Ai, les piliers 503Ai et les motifs diélectriques 704Ai et donc les cavités de Fabry-Pérot.

L'étape 617' consiste enfin à retirer par stripping ou gravure la résine 713 restante ainsi que le matériau à bas ou haut indice optique localisé au-dessus de la résine.

Qu'ils s'agissent des tranchées d'air 714 ou des murs d'isolation 714', ces derniers assurent une isolation complète de l'ensemble de la cavité de Fabry-Pérot ainsi que du transducteur photoélectrique qui lui est associé. En outre, chaque pilier de résine (ou réalisé dans le matériau de la sous-couche) sur lequel est déposé la première couche réfléchissante agit comme une structure qui guide les ondes lumineuses transmises du filtre vers le transducteur ou du transducteur vers le filtre : un tel agencement limite encore davantage le risque de cross talk entre deux filtres adjacents et deux transducteurs adjacents et augmente les performances électro-optiques des filtres.

**Revendications**

1. Procédé (100, 300) de fabrication d'un filtre multispectral pour une radiation électromagnétique, ledit filtre comportant au moins deux filtres de couleur, chaque filtre comportant une première couche réfléchissante, une deuxième couche réfléchissante, une couche en matériau diélectrique de cavité de Fabry-Pérot entre la première couche réfléchissante et la deuxième couche réfléchissante, l'épaisseur de la couche diélectrique des deux filtres de couleurs étant différente et chacun des deux filtres étant en regard d'un transducteur photoélectrique, ledit procédé comportant les étapes suivantes :

   - Dépôt sur un substrat porteur comportant au moins deux transducteurs photoélectriques, d'une couche de matériau de structuration;
   - Structuration (101, 102, 301, 302) en trois dimensions de la couche de matériau de structuration de sorte à obtenir au moins deux motifs de matériau de structuration de hauteurs différentes, au moins un des motifs présentant une hauteur maximale de référence relativement au substrat porteur, la hauteur étant mesurée perpendiculairement au plan du substrat, chacun des motifs étant en regard d'un transducteur photoélectrique ;
   - Dépôt conforme (104, 303) d'une première couche réfléchissante sur les au moins deux motifs de matériau de structuration ;
   - Dépôt (105, 304) d'une couche réalisée dans le matériau diélectrique destiné à former les motifs diélectriques des cavités de Fabry-Pérot, ladite couche de matériau diélectrique recouvrant la totalité des motifs en présentant une surface supérieure dont chaque point est situé à une hauteur supérieure à la hauteur maximale de référence ;
   - Planarisation (106, 305) par retrait du matériau diélectrique avec arrêt sélectif au sommet du motif de matériau de structuration le plus haut recouvert de la couche réfléchissante ;
   - Dépôt (107, 306) d'une couche réalisée dans le même matériau diélectrique de façon à finaliser la formation des cavités de Fabry-Pérot ;
   - Dépôt (108, 307) d'une seconde couche réfléchissante sur les au moins deux cavités de Fabry-Pérot.

2. Procédé (100) selon la revendication 1 **caractérisé en ce que** le matériau de structuration est une résine, ladite étape de structuration (101, 102) étant réalisée par une étape de lithographie en niveau de gris dite Grayscale sur la couche de matériau de structuration suivie d'une étape de réticulation de la résine.

3. Procédé selon la revendication précédente **caractérisé en ce que** l'étape de structuration est suivie, avant l'étape de dépôt conforme (104) de la première couche réfléchissante sur les au moins deux motifs de matériau de structuration, d'une étape de dépôt conforme (103) d'une couche d'encapsulation sur les au moins deux motifs de matériau de structuration, ladite première couche réfléchissante recouvrant la couche d'encapsulation.

4. Procédé (300) selon la revendication 1 **caractérisé en ce que** ledit matériau de structuration est un matériau isolant organique ou inorganique, ladite étape de structuration comportant les sous-étapes suivantes :

   - Dépôt (301) d'une couche de résine suivant l'étape de dépôt de la couche de matériau isolant organique ou inorganique ;
   - Lithographie (301) en niveau de gris dite Grayscale sur la couche de résine de façon à structurer en trois dimensions la couche de résine pour obtenir au moins deux motifs de résine de hauteurs différentes ;
   - Transfert (302) des deux motifs de résine dans la couche de matériau organique ou inorganique de façon à obtenir lesdits au moins deux motifs de matériau de structuration de hauteurs différentes.

**5.** Procédé (100, 300) selon l'une des revendications précédentes **caractérisé en ce que** le dépôt de la couche réalisée dans le matériau diélectrique destiné à former les motifs diélectriques des cavités de Fabry-Pérot et le dépôt d'une couche réalisée dans le même matériau diélectrique de façon à finaliser la formation des cavités de Fabry-Pérot sont des dépôts conformes.

**6.** Procédé selon l'une des revendications précédentes **caractérisé en ce que** l'étape de structuration (601) en trois dimensions de la couche de matériau de structuration est une étape d'obtention d'au moins deux motifs de matériau de structuration de hauteurs différentes présentant un espace vide entre lesdits au moins deux motifs de structuration.

**7.** Procédé selon la revendication précédente **caractérisé en ce qu'**il comporte, après l'étape de dépôt conforme de la première couche réfléchissante et avant le dépôt de la couche réalisée dans le matériau diélectrique destiné à former les motifs diélectriques des cavités de Fabry-Pérot, les étapes suivantes :

- Dépôt (603) d'une couche, dite couche d'isolation, ladite couche d'isolation recouvrant la totalité des motifs de matériau de structuration en présentant une surface supérieure dont chaque point est situé à une hauteur relativement au substrat porteur supérieure à la hauteur maximale de référence ;
- Dépôt (604) d'une couche de résine au-dessus de ladite couche d'isolation ;
- Retrait (605) de la résine afin de conserver la résine uniquement au-dessus du ou des espace(s) vide(s) entre les motifs de matériau de structuration et laisser la couche d'isolation apparente au-dessus des motifs de matériau de structuration ;
- Retrait (606) du matériau de la couche d'isolation dans la zone apparente de la couche d'isolation ;
- Retrait (607) de la résine restante afin de conserver des murs réalisés dans ledit matériau de la couche d'isolation entre les motifs de matériau de structuration.

**8.** Procédé selon la revendication 6 **caractérisé en ce qu'**il comporte, après l'étape de dépôt conforme de la première couche réfléchissante et avant le dépôt de la couche réalisée dans le matériau diélectrique destiné à former les motifs diélectriques des cavités de Fabry-Pérot, les étapes suivantes :

- Dépôt (603') d'une couche de résine recouvrant la totalité des motifs de matériau de structuration en présentant une surface supérieure dont chaque point est situé à une hauteur relativement au substrat porteur supérieure à la hauteur maximale de référence ;
- Retrait (604') de la résine entre les motifs de matériau de structuration afin de conserver la résine uniquement au-dessus des motifs de matériau de structuration ;
- Dépôt (605') d'une couche, dite couche d'isolation, ladite couche d'isolation recouvrant la totalité des motifs de matériau de structuration recouvert de résine et remplissant les espaces entre lesdits motifs, en présentant une surface supérieure dont chaque point est situé à une hauteur relativement au substrat porteur supérieure à la hauteur maximale de référence ;
- Retrait (606') du matériau de la couche d'isolation situé au-dessus des motifs de matériau de structuration et de la résine restante afin de conserver des murs réalisés dans ledit matériau de la couche d'isolation entre les motifs de matériau de structuration.

**9.** Procédé selon l'une des revendications 7 ou 8 dans lequel ledit matériau de la couche d'isolation est un matériau sacrificiel, ledit procédé étant **caractérisé en ce qu'**il comporte les étapes suivantes :

- Dépôt (613) d'une couche de résine sur la seconde couche réfléchissante ;
- Retrait (614) de la résine dans les zones au-dessus du ou des espace(s) entre les motifs de matériau de structuration ;
- Retrait (615, 616) du matériau de la seconde couche réfléchissante, du matériau diélectrique destiné à former les motifs diélectriques des cavités de Fabry-Pérot et du matériau sacrificiel dans les zones au-dessus du ou des espace(s) entre les motifs de matériau de structuration de façon à former des murs de vide entre les motifs de matériau de structuration et entre les cavités de Fabry-Pérot les surplombant ;
- Retrait (617) de la résine restante.

**10.** Procédé selon l'une des revendications 7 ou 8 dans lequel ledit matériau de la couche d'isolation est un matériau diélectrique à bas indice optique, **caractérisé en ce qu'**il comporte les étapes suivantes :

- Dépôt (613) d'une couche de résine sur la seconde couche réfléchissante ;
- Retrait (614) de la résine dans les zones au-dessus du ou des espace(s) entre les motifs de matériau de structuration ;
- Retrait (615) du matériau de la seconde couche réfléchissante et du matériau diélectrique dans les zones non protégées par la résine restante de façon à accéder au matériau diélectrique à bas indice optique ;
- Dépôt (616') d'une couche du matériau diélectrique à bas indice optique au-dessus de la résine restante et venant compléter le matériau diélectrique déjà présent entre les motifs de matériau de structuration de façon à combler le vide entre les cavités de Fabry-Pérot les surplombant ;

- Retrait (617') de la résine et du matériau diélectrique à bas indice optique au-dessus des zones de résine en laissant le matériau à bas indice optique entre les motifs de matériau de structuration et entre les cavités de Fabry-Pérot les surplombant de façon à former des murs d'isolation diélectrique.

[Fig. 1]

[Fig. 2]

[Fig. 3]

[Fig. 4]

[Fig. 5]

[Fig. 6]

[Fig. 7]

[Fig. 8]

[Fig. 9]

Europäisches
Patentamt

European
Patent Office

Office européen
des brevets

# RAPPORT DE RECHERCHE EUROPEENNE

**Numéro de la demande**

EP 24 18 1316

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2008/159658 A1 (YUN YOUNG JE [KR]) 3 juillet 2008 (2008-07-03) * alinéa [0016] - alinéa [0053]; figures 1-6 * | 1-10 | INV. H01L27/146 H01L31/0216 |
| | ----- | | |
| A | US 2014/085727 A1 (CHEN LINSEN [CN] ET AL) 27 mars 2014 (2014-03-27) * alinéa [0016] - alinéa [0024]; figure 3 * | 3,5 | |
| | ----- | | |
| A | US 2021/255543 A1 (WILLIAMS CALUM [GB] ET AL) 19 août 2021 (2021-08-19) * alinéa [0073] - alinéa [0074]; figure 2 * | 2,4 | |
| | ----- | | |
| A | US 2017/294478 A1 (CUI HUSHAN [CN] ET AL) 12 octobre 2017 (2017-10-12) * alinéa [0020] - alinéa [0188]; figures 1-15 * | 1 | |
| | ----- | | |

**DOMAINES TECHNIQUES RECHERCHES (IPC)**

H01L

Le présent rapport a été établi pour toutes les revendications

| Lieu de la recherche | Date d'achèvement de la recherche | Examinateur |
|---|---|---|
| La Haye | 2 octobre 2024 | Hedouin, Mathias |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 24 18 1316

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

02-10-2024

| Document brevet cité au rapport de recherche | Date de publication | Membre(s) de la famille de brevet(s) | | Date de publication |
|---|---|---|---|---|
| US 2008159658 A1 | 03-07-2008 | CN | 101211946 A | 02-07-2008 |
| | | KR | 100819706 B1 | 04-04-2008 |
| | | US | 2008159658 A1 | 03-07-2008 |
| US 2014085727 A1 | 27-03-2014 | CN | 102798917 A | 28-11-2012 |
| | | US | 2014085727 A1 | 27-03-2014 |
| | | WO | 2012159397 A1 | 29-11-2012 |
| US 2021255543 A1 | 19-08-2021 | EP | 3807682 A1 | 21-04-2021 |
| | | GB | 2574805 A | 25-12-2019 |
| | | JP | 2021527238 A | 11-10-2021 |
| | | US | 2021255543 A1 | 19-08-2021 |
| | | WO | 2019239139 A1 | 19-12-2019 |
| US 2017294478 A1 | 12-10-2017 | CN | 105742306 A | 06-07-2016 |
| | | US | 2017294478 A1 | 12-10-2017 |

EPO FORM P0460

Pour tout renseignement concernant cette annexe : voir Journal Officiel de l'Office européen des brevets, No.12/82

**EP 4 478 416 A1**

**RÉFÉRENCES CITÉES DANS LA DESCRIPTION**

**Documents brevets cités dans la description**

- GB 2574805 A